# EUROPÄISCHE PATENTSCHRIFT

(11) **EP 0 662 247 B1**
(45) Veröffentlichungstag und Bekanntmachung des Hinweises auf die Patenterteilung: **10.03.1999**
(21) Anmeldenummer: 93918951.0
(22) Anmeldetag: 07.09.1993
(51) Int. Cl.: H01L 31/18, H01L 31/032

(54) **SCHNELLES VERFAHREN ZUR ERZEUGUNG EINES CHALKOPYRIT-HALBLEITERS AUF EINEM SUBSTRAT**
PROCESS FOR RAPIDLY GENERATING A CHALKOPYRITE SEMICONDUCTOR ON A SUBSTRATE
PROCEDE RAPIDE DE REALISATION D'UN SEMI-CONDUCTEUR EN CHALCOPYRITE SUR UN SUBSTRAT

(30) Priorität: 22.09.1992 DE 4231706
(43) Veröffentlichungstag der Anmeldung: 12.07.1995
(73) Patentinhaber: SIEMENS AKTIENGESELLSCHAFT, 80333 München (DE)
(72) Erfinder: KARG, Franz, D-81671 München (DE); PROBST, Volker, D-81547 München (DE)
(86) Internationale Anmeldenummer: DE9300814
(87) Internationale Veröffentlichungsnummer: WO9407269

(56) Entgegenhaltungen:
- EP-A- 0 318 315
- DE-A- 3 822 073
- SOLAR CELLS. Bd. 30, Nr. 1/4 , Mai 1991 , LAUSANNE CH Seiten 69 - 77 G.D. MOONEY ET AL. 'The formation of CuInSe2 thin films by rapid thermal processing'
- 9TH E.C. PHOTOVOLTAIC SOLAR ENERGY CONFERENCE 25. September 1989 , FREIBURG, FRG Seiten 153 - 156 H. OUMOUS ET AL. 'Production of CuInSe2 thin films by rapid thermal annealing of stacked elemental layers' in der Anmeldung erwähnt
- SOLAR ENERGY MATERIALS AND SOLAR CELLS Bd. 27, Nr. 1 , Juni 1992 , AMSTERDAM NL Seiten 13 - 23 N. KAVCAR ET AL. 'Characterization of CuInSe2 thin films produced by thermal annealing of stacked elemental layers'
- TENTH E.C. PHOTOVOLTAIC SOLAR ENERGY CONFERENCE 8. April 1991 , LISBON, PORTUGAL Seiten 883 - 886CA M.H. BADAWI ET AL. 'Scaleable, large area compatible technique for the production of CuInSe2 based solar cells'
- 20TH IEEE PHOTOVOLTAIC SPECIALISTS CONFERENCE 26. September 1988 , LAS VEGAS, USA Seiten 1482 - 1486 A. KNOWLES ET AL. 'Properties of copper indium diselenide thin films produced by thermal annealing of elemental sandwich structures'
- 22ND IEEE PHOTOVOLTAIC SPECIALISTS CONFERENCE 7. Oktober 1991 , LAS VEGAS, USA Seiten 1169 - 1172 M. TANDA ET AL. 'Photoluminescence study of CuInSe2 thin films prepared by the selenization technique'

## Beschreibung

Zur preiswerten und konkurrenzfähigen Energieerzeugung durch Umwandlung von Sonnenlicht in elektrische Energie werden hocheffiziente Solarzellen benötigt. Diese sollten einen Wirkungsgrad von über 10 Prozent, besser noch über 15 Prozent besitzen und über einen Zeitraum von mindestens 20 Jahren stabil sein.

Für Solarzellenzwecke werden derzeit Verbindungshalbleiter vom Chalkopyrit-Typ intensiv untersucht. Mit polykristallinen Dünnfilmsolarzellen aus zum Beispiel Kupfer-Indium-Diselenid (CIS) wurden bereits hohe und stabile Wirkungsgrade von nahezu 15 Prozent erreicht. Für eine großtechnische Fertigung solcher Solarzellen ist jedoch noch weitere Zellen- und Verfahrensentwicklung notwendig. Zum einen sollte die Entwicklung den Fertigungsprozeß weiter vereinfachen, der zum Erreichen hoher Wirkungsgrade der produzierten Solarzellen eine aufwendige Verfahrenskontrolle erfordert. Zum anderen sollten toxische Verbindungen wie Selenwasserstoff, Kadmiumsulfid oder Kadmiumtellurid oder aus dem Herstellungsprozeß bzw. aus der Zellenstruktur eleminiert werden.

Die bisher bekanntgewordenen Schichtbildungsverfahren zur Herstellung von Chalkopyrit-Dünnfilmen können im wesentlichen nach Ein- bzw. Zweistufenprozessen unterschieden werden. Ein zum Beispiel aus der EP 67860 B (Mickelsen et al) bekannter Einstufenprozeß sieht ein simultanes Aufdampfen der Elemente Cu, In oder Ga und Se oder S auf ein beheiztes Substrat vor, wobei sich spontan der Verbindungshalbleiter auf dem Substrat ausbildet. Dabei muß jedoch die Aufdampfrate der Elemente Cu und In bzw. Cu und Ga sowie insbesondere deren Verhältnis zueinander sehr genau geregelt werden. Diese Anforderung wirft große Probleme bei der Herstellung großflächiger Solarmodule auf.

Im Unterschied dazu werden beim zum Beispiel aus der EP 195152 B bekannten Zweistufenprozeß zunächst die Metallschichten (zum Beispiel Cu und In) bei Raumtemperatur abgeschieden. In einem zweiten Schritt wird daraus durch einen Temperprozeß in reaktiver selen- oder schwefelhaltiger Atmosphäre die gewünschte Halbleiterverbindung gebildet. Zwar läßt sich dieser Zweistufenprozeß auf Großflächenbeschichtungsanlagen übertragen und die Mengenverhältnisse der einzelnen Komponenten besser kontrollieren, doch tritt dabei häufig eine mangelnde Haftung der Halbleiterschicht an der metallischen Rückelektrode auf. Außerdem muß ein genaues Temperaturprofil sowie ein ausreichender Selenpartialdruck beim Aufheizen der Probe eingehalten werden, um die gewünschten Schichteigenschaften zu erhalten. Ein weiteres Problem stellt das hochtoxische für das Verfahren erforderliche Prozeßgas Selenwasserstoff und in eingeschränkter Form auch der Schwefelwasserstoff dar. Außerdem läßt sich mit dem langwierigen Prozeß von mehreren Stunden Dauer nur eine diskontinuierliche Fertigung realisieren, die den Mengenumsatz stark einschränkt.

In einer weiteren Variante des Zweistufenprozesses wird die Selen- bzw. Schwefelkomponente nicht über die Gasphase eingebaut, sondern direkt in elementarer Form auf das metallische Schichtpaket aufgedampft. Dabei verläuft die Halbleiterbildung zwar schneller als in den obengenannten Fällen, doch erweisen sich daraus hergestellte Dünnfilmsolarzellen als unbefriedigend und zeigen nur Wirkungsgrade von unter 5 Prozent. Die Schichten zeigen Reste von Sekundärphasen sowie punktuelle Ablösungen vom Substrat.

In einer weiteren Variation dieses Prozesses werden CIS-Dünnfilme mittels Laser durch RTA (Rapid Thermal Annealing) aus Cu/In/Se Schichtpaketen synthetisiert. Die dabei erhaltenen Halbleiterschichten waren jedoch nicht einphasig, von zu geringer Korngröße und außerdem n-leitend.

Aus einem Beitrag von H. Oumous et al in Proc. Of the 9^{th} EC PVSEC 1989, Freiburg/Breisgau, Seiten 153 bis 156, ist es zum Beispiel bekannt, einen aus neun Elementarschichten In/Se/Cu bestehenden Stapel mit 10°C/s auf 350 bis 500°C zu erhitzen. Auch dieser Prozeß führt neben der Chalkopyritphase zu röntgendiffraktometrisch nicht nachweisbaren Fremdphasen. Diese ergeben unbrauchbare Solarzellen. Auch ist der Multischichtaufbau verfahrensaufwendig und/oder nicht auf großflächigen Substratn zu realisieren. Es werden zu geringe Korngrößen und eine zu geringe Schichtdickengleichmäßigkeit beobachtet.

Aus einem Beitrag zur 20. IEEE Photovoltaic Specialist Conference, Las Vegas, 26. bis 30. September 1998, Seiten 1482 bis 1486 ist ein Herstellungsverfahren für Kupferindiumdiselenid-Dünnschichten bekannt, bei dem ein sandwichartiger Stapel dünner Elementarschichten der Ausgangskomponenten auf einem Glassubstrat durch eine Laserbehandlung in den Verbindungshalbleiter überführt wird. Eine thermische Behandlung in Vakuum oder in einer Inertatmosphäre schließt sich an.

Aus Solar Cells, Band 30, No. ¼, Mai 1991, Seiten 69 bis 77 ist ein Verfahren zur Herstellung von Kupferindiumdiselenid-Dünnschichten auf polykristallinen Substraten bekannt. Die elementaren Ausgangsverbindungen werden durch gemeinsame Abscheidung (Codeposition) durch Vakuumaufdampfen abgeschieden und in einem schnellen Aufheizprozeß in den Halbleiter überführt.

Aus DE-A-38 22 073 ist die Herstellung von dünnen Kupferindiumdiselenid-Schichten durch thermische Behandlung dünner elementarer Schichten der Ausgangsverbindungen bekannt.

Aus EP-A-318 315 ist ein Herstellungsverfahren für Chalkopyrit-Halbleiterschichten bekannt, bei dem Elementarschichtenstapel der Ausgangskomponenten in einer Wasserstoff- oder Wasserstoffselenid-haltigen Atmosphäre in den Verbindungshalbleiter überführt werden.

Aufgabe der vorliegenden Erfindung ist es daher, ein verbessertes Verfahren zur Herstellung eines Chalkopyrit-Halbleiters anzugeben, welches einfach durchzuführen und gut kontrollierbar ist und welches einen einphasigen und homogenen Halbleiter erzeugt, aus dem sich Solarzellen mit hohen Wirkungsgraden herstellen lassen. Außerdem soll die Prozeßführung durch Vermeidung toxischer Gase sicher sein.

Diese Aufgabe wird erfindungsgemäß gelöst durch ein Verfahren nach Anspruch 1. Weitere Ausgestaltungen der Erfindung sind den Unteransprüchen zu entnehmen.

Die wichtigsten Parameter für das erfindungsgemäße Verfahren sind die hohe Aufheizrate AR von zumindest 10°C pro Sekunde und der während des Temperprozesses einzuhaltende Überdruck an der Komponente C. Unter Überdruck wird in dem Sinn ein Partialdruck verstanden, der über dem Partialdruck liegt, der sich über einer stöchiometrisch exakten Zusammensetzung der Ausgangskomponenten A, B und C im Verhältnis 1 : 1 : 2 ausbilden würde.

Mit der angegebenen hohen Aufheizrate und einer ausreichend hohen Prozeßtemperatur T_{P} ist der fertige Verbindungshalbleiter bereits nach einer Temperzeit dt von wenigen Sekunden ausgebildet. Gegenüber bekannten Verfahren, die zumindest eine Stunde Selenisierung erfordern, handelt es sich somit um ein äußerst schnelles Verfahren.

Der Überdruck an der Komponente C bewirkt eine Selbstregulierung der Stöchiometrie des erhaltenen Verbindungshalbleiters. Auch bei einem Schichtaufbau mit einer nicht exakten 1 : 1 : 2 Zusammensetzung bezüglich der Ausgangskomponenten A, B und C wird ein homogener das heißt einphasiger Verbindungshalbleiter der exakt richtigen Zusammensetzung erhalten.

Durch die hohe Aufheizrate des Schichtaufbaus wird eine direkte Reaktion der Ausgangskomponenten zum gewünschten Verbindungshalbleiter erreicht. Bisher auftretende stabile, aber elektronisch störende Zwischenstufen wie zum Beispiel das Cu_{2-d}Se werden vermieden, da sich direkt der gewünschte Halbleiter bildet. Die entstehende Halbleiterschicht zeigt eine hohe Haftung auf dem Substrat, welches mit einer Rückelektrode versehen oder ohne Rückelektrode sein kann. Punktuelle Schichtablösungen treten nicht auf, da durch die hohe Aufheizrate AR lokale Zusammenballungen einzelner Elemente des Schichtaufbaus SA und deren binäre Zwischenphasen vermieden werden. Ein damit verbundenes laterales und damit ungleichmäßiges Schichtwachstum als Ursache für Schichtaufwölbungen wird verhindert. Es wird ein homogenes Schichtwachstum beobachtet, welches zu einer äußerst homogenen Verbindungshalbleiterschicht mit äußerst geringen Schichtdickenschwankungen führt.

Die Korngröße des Chalkopyrit-Halbleiters liegt im Bereich vom ein- bis dreifachen der erzeugten Schichtdicke, so daß die Halbleiterschicht keine parallel zur Schichtebene verlaufenden Korngrenzen besitzt, die die Brauchbarkeit der Halbleiterschicht zur Herstellung von Solarzellen beeinträchtigen würde.

Daraus hergestellte Solarzellen zeigen Wirkungsgrade von über 10 Prozent.

Der Überdruck der Komponente C wird anfänglich durch einen stöchiometrischen Überschuß und während des Temperprozesses durch eine Verkapselung des Schichtaufbaus gewährleistet. Unter Verkapselung wird dabei ein begrenzter und "geschlossener" Gasraum über dem Schichtaufbau verstanden. Einfache Lösungen für eine solche Verkapselung werden durch eine Abdeckung mit einem geeigneten und gegenüber dem Prozeß inerten Material erreicht. Eine weitere Möglichkeit besteht darin, das Substrat mit dem Schichtaufbau zur Temperung in einem geschlossenen Behälter aufzubewahren. Günstig ist dabei jeweils eine geringe Leckrate des durch die Verkapselung eingeschlossenen Volumens, die einen langsamen Gasaustausch mit erhöhtem Strömungswiderstand erlaubt.

Das Material bzw. die Art der Abdeckung ist dabei auf die Art der Aufheizung abgestimmt. Eine schnelle Aufheizung läßt sich beispielsweise erreichen, wenn das Substrat mit dem Schichtaufbau zur Verkapselung in eine Graphitbox eingestellt wird und dann mittels Halogenlampen bestrahlt wird. Durch die hohe Absorption des Graphits wird ein so schnelles Aufheizen erreicht, daß die Prozeßtemperatur T_{P} in weniger als 10 Sekunden erreicht ist. Außerdem wird mit dem genannten Aufbau ein Überdruck an Reaktionsprodukten mit hohem Dampfdruck erzielt, bzw. der exzessive Verlust der Komponente C aufgrund deren hohen Dampfdrucks während der Temperung verhindert. Der Abstand der Schichtabdeckung von der Oberfläche des Schichtaufbaus sollte dabei kleiner als 5 cm und vorzugsweise kleiner als 5 mm sein.

Bei optischer Aufheizung des Substrats kann die Abdeckung bzw. Verkapselung auch aus anderen absorbierenden und nicht reflektierenden Materialien oder auch aus transparentem Material wie Quarz bestehen.

Neben der optischen Aufheizung sind auch andere Verfahren möglich, mit denen sich die hohe Aufheizrate erreichen läßt, beispielsweise Widerstandsheizung oder induktive Heizung.

Der Aufheiz- und der Temperprozeß werden unter einer Prozeßatmosphäre aus Inertgas wie zum Beispiel Stickstoff oder Argon durchgeführt. Der Prozeßdruck während des überwiegenden Teils der Temperung liegt dabei über 1 hpa, vorzugsweise aber nahe dem Atmosphärendruck, also knapp unterhalb 1.000 hpa.

Die Herstellung eines Schichtaufbaus und dessen Umwandlung in eine Schicht des Verbindungshalbleiters ABC₂ wird im folgenden anhand der Figuren 1 und 2 erläutert, während Figur 3 einen Querschnitt durch eine daraus hergestellte Solarzelle zeigt.

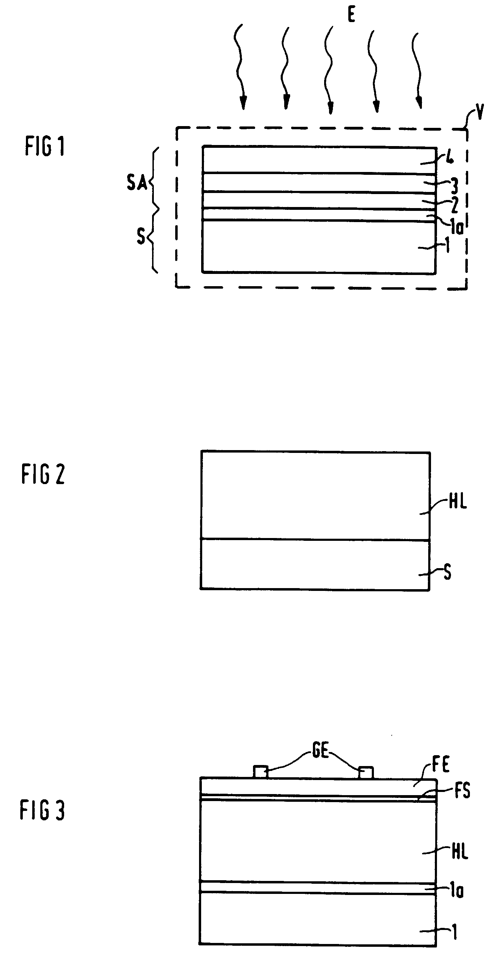

Als Substrat S dient üblicherweise eine Glasplatte 1 aus Fensterglas. Diese kann mit einer Haftschicht, beispielsweise einer dünnen Chromschicht versehen sein, auf der die Rückelektrodenschicht la für das aus der Halbleiterschicht zu fertigende Bauelement aufgebracht ist. Das Verfahren ist jedoch nicht auf diese Materialien beschränkt, so daß viele Substrat/Rückelektroden-kombinationen S möglich sind, die üblicherweise bei Solarzellen Verwendung finden. So kann das Substrat 1 aus beliebigen nicht leitenden oder leitenden Materialien hergestellt sein, beispielsweise aus Keramik, Graphit oder Stahl. Die Rückelektrodenschicht la kann eine beliebige Metallschicht sein oder auch ein dünnes leitfähiges Oxid, beispielsweise dotiertes Zinn- oder Zinkoxid. In Abhängigkeit vom Material des Substrats 1 und der Rückelektrodenschicht la kann zwischen SA und S (Figur 1) eine Diffusionssperrschicht erforderlich sein, wie zum Beispiel Titannitrid oder Tantalsiliziumnitrid.

Auf das Substrat S werden nun mit gängigen Dünnfilmbeschichtungsverfahren die einzelnen Schichten des Schichtaufbaus SA aufgebracht. Geeignete Verfahren sind zum Beispiel Sputtern, Aufdampfen oder galvanische Abscheidung. Die Gesamtschichtdicke des Schichtaufbaus SA ist von der gewünschten Schichtdicke des fertigen Verbindungshalbleiters abhängig, die beispielsweise zwischen 0,1 und 5 µm liegen sollte. Eine CIS-Schicht absorbiert das Sonnenlicht bereits ab einer Schichtdicke von 1 µm vollständig, so daß für Solarzellen geeignete CIS-Schichten üblicherweise in einer Dicke von zumindest 1 µm erzeugt werden.

Für den Schichtaufbau SA werden die Komponenten A, B und C des herzustellenden Verbindungshalbleiters ABC₂ in konkreten Schichten und in einem geeigneten Verhältnis der Komponenten zueinander aufgebracht. Möglich ist es auch, die Komponenten B und C zumindest teilweise als Interelementverbindungen abzuscheiden (zum Beispiel In₂Se₃ oder Ga₂Se₃). Die zum gewünschten Verhältnis der Komponenten B und C fehlende Menge an C wird elementar aufgetragen. Möglich ist es auch, die Komponenten B und C als Legierung aufzubringen und beispielsweise aufzudampfen.

Die Komponente A wird als erste Schicht 2 elementar aufgebracht. Die Schichten 3 und 4 enthalten wie oben beschrieben die Komponenten B und C bzw. BC-Verbindungen neben elementar aufgebrachtem C. Möglich ist es auch, die Reihenfolge der Schichten 3 und 4 zu vertauschen, oder die Gesamtmenge an den Komponenten A, B und C in Form von mehr als drei Schichten als Multischicht aufzubringen.

Die Komponenten A, B und C werden in einem Mol-Verhältnis von 1 : m : 2 n abgeschieden, wobei m einen Wert von 0,9 bis 1,3 annehmen kann, üblicherweise aber größer als 1 ist. Der Index n kann einen beliebigen Wert von 1,0 bis 1,8 annehmen, wird aber insgesamt stets so gewählt, daß die Komponente C im Überschuß vorliegt, so daß der Anteil an C beispielsweise 20 bis 100 Prozent über dem stöchiometrisch exakten Anteil in bezug auf A und/oder B liegt, wobei natürlich die im Unterschuß vorliegende Komponente als Maßstab genommen wird.

Gemäß einer Ausführung der Erfindung werden die Komponenten A und B in einer Menge von zumindest 2 µmol/cm² und die Komponente C in einer Menge von zumindest 4,8 µmol/cm² auf dem Substrat S aufgebracht.

In einer weiteren Ausgestaltung der Erfindung ist vorgesehen, die Komponenten B und/oder C in Anteilen von je 0 bis 25 Atom-Prozent durch je ein Element derselben Hauptgruppe des Periodensystems zu ersetzen.

Die Beschichtungstemperatur für den Schichtaufbau SA bzw. für die Schichten 2, 3 und 4 liegt unter 200°C und ist im einzelnen von der Aufbringungsart abhängig.

Zur Umwandlung des Schichtaufbaus SA muß dieser nun einem Temperaturprozeß unterworfen werden. Dazu wird der Schichtaufbau SA zunächst verkapselt, beispielsweise durch Abdeckung des Schichtaufbaus oder Einbringen des Substrats S mit dem Schichtaufbau SA in einen geschlossenen Behälter. Die Abdeckung kann mittels einer Folie oder einer dünnen Platte erfolgen, und beispielsweise aus Metall, Graphit oder Quarz bestehen. In der Figur 1 ist die Verkapselung als durchbrochene Linie dargestellt. Durch die Verkapselung V kann sich während des Temperprozesses ein Überdruck an Reaktionsprodukten oder eingesetzten Komponenten mit hohem Dampfdruck aufbauen, wobei gleichzeitig ein langsamer Gasaustausch nach außen ermöglicht wird.

Das Zuführen von Energie, beispielsweise durch Strahlung E mittels Halogenlampen, muß eine ausreichend hohe Aufheizrate AR gewährleisten können, so daß alle unter diesen Gesichtspunkten geeigneten Heizquelle und Materialien zur Verkapselung verwendet werden können.

Der Temperprozeß umfaßt eine schnelle Aufheizphase auf die Prozeßtemperatur T_{P} von zumindest 350°C. Die Aufheizzeit sollte dabei unter 30 Sekunden, vorzugsweise unter 10 Sekunden liegen, so daß eine Aufheizrate AR von zumindest 10°C pro Sekunde erforderlich ist. Nach dem Erreichen der Prozeßtemperatur wird noch für eine Zeitspanne dt weitergetempert, wobei dt in Abhängigkeit von T_{P} von wenigen Sekunden bis ca. 1 Stunde betragen kann. Beispielsweise ist bei 500°C eine Temperzeit von 20 Sekunden ausreichend, während eine Prozeßtemperatur von 400°C eine Temperzeit von 5 Minuten (jeweils für CIS) erfordert.

Figur 2 zeigt das Substrat S mit der darauf erzeugten Halbleiterschicht HL. Die Halbleiterschicht HL ist einphasig, besteht also nur aus Kristallkörnern des gewünschten Verbindungshalbleiters ABC₂. Die erreichten Korngrößen sind abhängig von der gewählten Prozeßtemperatur T_{P} oder Aufheizrate AR und von der Schichtdicke d der erzeugten Halbleiterschicht HL und liegen im Bereich von 1d bis 3d. Damit ist gewährleistet, daß in der Halbleiterschicht HL nur senkrecht zur Schichtebene verlaufende Korngrenzen auftreten welche eine hohe elektronische Qualität der Halbleiterschicht sichern.

Als Ausführungsbeispiel wird im folgenden die Herstellung einer CIS-Schicht sowie einer darauf basierenden Solarzelle beschrieben.

### Ausführungsbeispiel

Für das Substrat S wird Natron-Kalk Glas verwendet und mit einer Molybdänelektrode versehen. Dazu wird ca. 1 µm dick Molybdän aufgesputtert. Für den Schichtaufbau SA werden die Komponenten A, B und C in Form diskreter Schichten der Elemente Cu, In und Se in der genannten Reihenfolge aufgebracht, wobei für Cu eine Gesamtmenge von 2 µmol/cm², für In eine Menge von 2,15 µmol/cm² und für Se eine Menge von 5,8 µmol/cm² gewählt wird, was für eine Schichtdicke d der fertigen CIS-Schicht von ca. 1 um ausreichend ist. Für andere Schichtdicken d sind die Auftragsmengen entsprechend zu korrigieren.

Das Substrat mit dem Schichtaufbau SA wird nun in einer Graphitbox mit einer Aufheizrate von 50°C pro Sekunde durch Verwendung von Halogenlampen auf 400°C in einer Atmosphäre aus Stickstoff und unter einem Druck von ca. 800 hpa erhitzt. Nach einer Temperzeit von ca. 5 Minuten ist ein gut haftender, polykristalliner einphasiger CIS-Film in Chalkopyrit-Struktur entstanden, wie das Röntgenbeugungsspektrometrum beweist. Die Korngröße liegt im Bereich von 1 bis 3 µm, der Film ist p-leitend mit einem spezifischen Widerstand von ca. 50 bis 100 Ohm cm.

Zur Fertigstellung einer Solarzelle wird darüber nach bekannten Methoden eine 10 nm dicke n-leitende Kadmiumsulfid/Zinkoxid-Fensterschicht FS erzeugt. Eine Frontelektrodenschicht FE, zum Beispiel 1 µm dickes ZnO sowie eine Gridelektrodenstruktur GE und gegebenenfalls eine Passivierungs- bzw. Antireflexschicht vervollständigen den Aufbau.

Die fertigen Solarzellen zeigen Wirkungsgrade über 10 Prozent bei einer Leerlaufspannung von über 415 mV, einem Füllfaktor von über 65 Prozent und einem Kurzschlußstrom von über 38 mA/cm². Figur 3 zeigt die fertige Solarzelle.

Das erfindungsgemäße Verfahren ist neben dem für Solarzellen bewährten Kupferindiumdiselenid auch zur Herstellung der anderen Chalkopyrit-Materialien bestens geeignet. Gegenüber herkömmlichen Prozessen werden mit dem neuen Verfahren deutlich reduzierte Taktzeiten erzielt, so daß sich damit eine nahezu kontinuierliche kostengünstige In-Line Fertigung realisieren läßt.

Gegenüber einer Gasphasenselenisierung zur Herstellung einer CIS-Schicht ergibt sich mit dem erfindungsgemäßen Verfahren für den Verfahrensschritt der Halbleiterbildung eine bis zu 200-fache Beschleunigung.

## Patentansprüche

1. Verfahren zur Herstellung eines Chalkopyrit-Halbleiters des Typs ABC₂, worin A für Kupfer, B für Indium oder Gallium und C für Schwefel oder Selen steht, auf einem Substrat mit den Schritten
- Erzeugen eines Schichtaufbaus (SA) auf dem Substrat (S) durch Aufbringen der Komponenten A, B und C in elementarer Form und/oder als binäre Interelementverbindung B₂C₃, wobei die Komponente C in Bezug auf die im Unterschuß vorliegende Komponenten A und/oder B in einem Überschuß vorliegt, der bis zum Zweifachen des stöchiometrisch exakten Anteils an Komponente C ausmacht,
- schnelles Aufheizen des Substrats (s) mit dem Schichtaufbau (SA) unter einer Prozeßatmosphäre aus Inertgas auf eine Prozeßtemperatur (T_{P}), die größer oder gleich 350°C ist, mit einer Aufheizrate (AR) von zumindest 10°C/Sekunde und
- Halten des Substrats bei Tp für eine Zeitspanne dt von 10 Sekunden bis 1 Stunde,
wobei durch eine Abdeckung im Abstand von weniger als 5 mm über dem Schichtaufbau eine Verkapselung vorgesehen wird, die während des gesamten Temperprozesses einen Partialdruck für die Komponente C aufrechterhält, der über dem Partialdruck von C liegt, der sich über einem stöchiometrisch exakten ABC₂-Halbleiter (A:B:C = 1:1:2) ausbilden würde.

2. Verfahren nach Anspruch 1,
bei dem das Substrat (S) mit dem Schichtaufbau (SA) zur Verkapselung in einem geschlossenen Behälter (V) verwahrt wird.

3. Verfahren nach Anspruch 2,
bei dem ein Behälter (V) aus Graphit verwendet wird un das Aufheizen (E) mit einer Heizlampe erfolgt.

4. Verfahren nch einem der Ansprüche 1 bis 3,
bei dem die Komponente A als erste Schicht (1) des Schichtaufbaus (SA) elementar aufgebracht wird.

5. Verfahren nach einem der Ansprüche 1 bis 4,
bei dem die Aufheizrate AR so hoch gewählt wird, daß die Prozeßtemperatur T_{P} in weniger als 10 Sekunden erreicht wird.

6. Verfahren nach einem der Ansprüche 1 bis 5,
bei dem die Prozeßtemperatur TP zumindest 500°C beträgt.

7. Verfahren nach einem der Ansprüche 1 bis 6,
bei dem die Temperung bei einem Gesamtgasdruck zwischen 1 hpa und 1000 hpa durchgeführt wird.

8. Verfahren nach einem der Ansprüche 1 bis 7,
bei dem für den Schichtaufbau SA die Komponenten A, B und C in einem Verhältnis von 1 : m : 2 n abgeschieden werden, wobei m gleich 0,9 bis 1,3 und n gleich 1,0 bis 1,8 ist.

9. Verfahren nach einem der Ansprüche 1 bis 8,
bei dem die Komponenten A und B in einer Menge von zumindest 2 µ mol/cm² und die Komponente C in einer Menge von zumindest 4,8 µ mol/cm² auf dem Substrat S aufgebracht werden.

10. Verfahren nach einem der Ansprüche 1 bis 9,
bei dem die Komponente B und/oder C in Anteilen von je 0 % bis 25 % Atomprozent ersetzt wird durch je ein Element derselben Hauptgruppe des Periodensystems.

## Claims

1. Process for producing a chalkopyrite semiconductor of the type ABC₂, where A is copper, B is indium or gallium and C is sulphur or selenium, on a substrate, comprising the steps of
- producing a layer structure (SA) on the substrate (S) by applying the components A, B and C in elemental form and/or as a binary interelemental compound B₂C₃, the component C being present in an excess, in relation to the components A and/or B which are present in an insufficient amount, which excess is up to twice the stoichiometrically exact proportion of component C,
- rapidly heating the substrate (S) with the layer structure (SA) under a processing atmosphere of inert gas to a processing temperature (T_{P}), which is greater than or equal to 350°C, at a heating rate (AR) of at least 10°C/s, and
- keeping the substrate at T_{P} for a time interval dt of 10 seconds to 1 hour,
characterized in that a covering is provided above the layer structure at a spacing of less than S mm for the purpose of encapsulation, which covering maintains, throughout the entire annealing process, a partial pressure for the component C which is above the partial pressure of C which would develop above a stoichiometrically exact ABC₂ semiconductor (A:B:C = 1:1:2).

2. Process according to Claim 1, characterized in that the substrate (S) with the layer structure (SA) is kept in a closed container (V) for the purpose of encapsulation.

3. Process according to Claim 2, characterized in that a graphite container (V) is used and the heating (E) is carried out with a heating lamp.

4. Process according to any of Claims 1 to 3, characterized in that the component A is applied in elemental form as first layer (1) of the layer structure (SA).

5. Process according to any of Claims 1 to 4, characterized in that the chosen heating rate AR is high enough for the processing temperature T_{P} to be reached in less than 10 seconds.

6. Process according to any of Claims 1 to 5, characterized in that the processing temperature T_{P} is at least 500°C.

7. Process according to any of Claims 1 to 6, characterized in that the annealing is carried out at a total gas pressure of between 1 hpa and 1000 hpa.

8. Process according to any of Claims 1 to 7, characterized in that the components A, B and C are deposited in a ratio of 1:m:2n for the layer structure SA, where m is equal to 0.9 to 1.3 and n is equal to 1.0 to 1.8.

9. Process according to any of Claims 1 to 8, characterized in that the components A and B are applied to the substrate S in an amount of at least 2 µmol/cm² and the component C is applied in an amount of at least 4.8 µmol/cm².

10. Process according to any of Claims 1 to 9, characterized in that the components B and/or C are/is each replaced by an element of the same main group of the periodic system in proportions of 0 per cent to 25 per cent (atomic per cent) in each case.

## Revendications

1. Procédé de réalisation d'un semi-conducteur en chalcopyrite du type ABC₂, où A est du cuivre, B de l'indium ou du gallium et C du soufre ou du sélénium, sur un substrat, comprenant les étapes suivantes :
- création d'une structure en couches (SA) sur le substrat (S) par dépôt des composants A, B et C sous forme élémentaire et/ou sous forme de composé interélémentaire binaire B₂C₃, le composant C étant présent en excès par rapport au composant A et/ou B présent en défaut, excès représentant jusqu'au double de la proportion stoechiométriquement exacte du composant C,
- échauffement rapide du substrat (S) avec la structure en couches (SA) sous une atmosphère de processus composée de gaz inerte jusqu'à une température de processus (Tₚ) supérieure ou égale à 350°C, à une vitesse d'échauffement (AR) d'au moins 10°C/seconde, et
- maintien du substrat à Tₚ pendant une durée dt comprise entre 10 secondes et 1 heure,
un encapsulage sous la forme d'un recouvrement placé à une distance de moins de 5 mm au-dessus de la structure en couches étant prévu, qui pendant l'ensemble du processus de recuit maintient une pression partielle du composant C, laquelle est supérieure à la pression partielle de C qui s'établirait au-dessus d'un semi-conducteur de type ABC₂ (A :B :C = 1:1:2) stoechiométriquement exact.

2. Procédé selon la revendication 1, dans lequel le substrat (S) avec la structure en couches (SA) est conservé dans un récipient fermé (V) pour l'encapsulage.

3. Procédé selon la revendication 2, dans lequel on utilise un récipient (V) en graphite et dans lequel l'échauffement (E) s'effectue à l'aide d'une lampe chauffante.

4. Procédé selon l'une des revendications 1 à 3, dans lequel le composant A représentant la première couche (1) de la structure en couches (SA) est déposé de façon élémentaire.

5. Procédé selon l'une des revendications 1 à 4, dans lequel la vitesse d'échauffement AR est telle que la température de processus Tₚ est atteinte en moins de 10 secondes.

6. Procédé selon l'une des revendications 1 à 5, dans lequel la température de processus Tₚ s'élève à au moins 500°C.

7. Procédé selon l'une des revendications 1 à 6, dans lequel le recuit s'effectue sous une pression de gaz totale comprise entre 1 hpa et 1000 hpa.

8. Procédé selon l'une des revendications 1 à 7, dans lequel les composants A, B et C sont déposés dans un rapport 1 :m :2n pour obtenir la structure en couches SA, m étant compris entre 0,9 et 1,3 et n entre 1,0 et 1,8.

9. Procédé selon l'une des revendications 1 à 8, dans lequel les composants A et B sont déposés sur le substrat S à raison d'au moins 2 µ mol/cm² et le composant C à raison d'au moins 4,8 µ mol/cm².

10. Procédé selon l'une des revendications 1 à 9, dans lequel les composants B et/ou C sont remplacés chacun dans des proportions de 0 à 25 % atomique par respectivement un élément du même groupe principal de la classification périodique.
